(19) Europäisches Patentamt
European Patent Office
Office européen des brevets

(11) **EP 2 453 577 B1**

(12) **EUROPÄISCHE PATENTSCHRIFT**

(45) Veröffentlichungstag und Bekanntmachung des Hinweises auf die Patenterteilung:
**04.04.2018 Patentblatt 2018/14**

(51) Int Cl.:
*H03M 1/06* (2006.01)  *H03M 1/10* (2006.01)

(21) Anmeldenummer: **11185915.3**

(22) Anmeldetag: **20.10.2011**

(54) **Verfahren und Vorrichtung zur Kompensation von Fehlanpassungen in Analog-Digital-Wandlern**

Method and device for compensating for mismatches in analogue-digital converters

Procédé et dispositif de compensation d'adaptations erronées dans des convertisseurs analogiques-numériques

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.11.2010 DE 102010051516**
**18.02.2011 DE 102011011711**

(43) Veröffentlichungstag der Anmeldung:
**16.05.2012 Patentblatt 2012/20**

(73) Patentinhaber: **Rohde & Schwarz GmbH & Co. KG**
**81671 München (DE)**

(72) Erfinder: **Nitsch, Bernhard**
**81825 München (DE)**

(74) Vertreter: **Körfer, Thomas et al**
**Mitscherlich PartmbB**
**Patent- und Rechtsanwälte**
**Sonnenstrasse 33**
**80331 München (DE)**

(56) Entgegenhaltungen:
**WO-A1-2008/156400     WO-A1-2009/098641**
**US-B1- 7 049 992**

- **"6 Wiener Filters" In: Saeed V. Vaseghi: "Advanced Digital signal Processing and Noise Reduction", 1. Januar 2000 (2000-01-01), John Wiley & Sons Ltd., XP002669032, ISBN: 0-471-62692-9 Seiten 178-204, * das ganze Dokument ***
- **VOGEL C ET AL: "Time-Interleaved Analog-to-digital converters: Status and future directions", 2006 IEEE INTERNATIONAL SYMPOSIUM ON CIRCUITS AND SYSTEMS 21-24 MAY 2006 ISLAND OF KOS, GREECE, IEEE - PISCATAWAY, NJ, USA, 21. Mai 2006 (2006-05-21), Seiten 3386-3388, XP002528698, DOI: 10.1109/ISCAS.2006.1693352 ISBN: 978-0-7803-9389-9**
- **CHAN S C ET AL: "A new method for designing FIR/IIR digital correction filters for time-interleaved analog-to-digital converter using second order cone programming", CIRCUITS AND SYSTEMS, 2007. MWSCAS 2007. 50TH MIDWEST SYMPOSIUM ON, IEEE, PISCATAWAY, NJ, USA, 5. August 2007 (2007-08-05), Seiten 1030-1033, XP031243320, ISBN: 978-1-4244-1175-7**

EP 2 453 577 B1

**Beschreibung**

Die Erfindung betrifft ein Verfahren und eine Vorrichtung zur Kompensation von Fehlanpassungen in mehreren zeitlich versetzt abtastenden Analog-Digital-Wandlern.

Zunehmend breitbandigere Anwendungen in der Telekommunikation erfordern Signalabtastungen mit einer Abtastrate, die von bisher erhältlichen Analog-Digital-Wandlern nicht realisierbar ist. Zur Erhöhung der Abtastrate werden mehrere Analog-Digital-Wandler parallel geschaltet und von demselben abzutastenden Eingangssignal beaufschlagt. Die parallel geschalteten Analog-Digital-Wandler tasten das Eingangssignal jeweils mit derselben Abtastrate, die um einen der Anzahl von parallel geschalteten Analog-Digital-Wandlern entsprechenden Faktor gegenüber der gewünschten Abtastrate reduziert ist, jeweils um einen Zeitversatz, der dem gewünschten Abtastintervall entspricht, zueinander versetzt ab (so genannte "time-interleaved A/D-Wandler" - bzw. zeitversetzte A/D-Wandler).

Derartige A/D-Wandler-Strukturen erfordern vollkommen identisch funktionierende Analog-Digital-Wandler. Aufgrund von Fehlanpassungen in realen A/D-Wandlern ist ein vollkommen identisches Betriebsverhalten der einzelnen A/D-Wandler nicht gegeben. Reale Analog-Digital-Wandler weisen typischerweise gegenüber idealen Analog-Digital-Wandlern folgende Fehler auf:

- unterschiedliche Impulsantworten $h_i(t)$ bzw. $h_j(t)$ sowie Übertragungsfunktionen $H_i(f)$ bzw. $H_j(f)$ zwischen unterschiedlichen Analog-Digital-Wandlern $i$ bzw. $j$,

- unterschiedliche Gleichanteile $o_i$ bzw. $o_j$ zwischen unterschiedlichen Analog-Digital-Wandlern $i$ bzw. $j$ und

- normierte Zeitversätze $\varepsilon_i$ bzw. $\varepsilon_j$ zu den einzelnen normierten Abtastzeitpunkten $M \cdot v + i$ bzw. $M \cdot v + j$ ($M$ : Anzahl der parallel geschalteten Analog-Digital-Wandler).

Zur Vereinfachung der Modellierung von Fehlanpassungen in den einzelnen Analog-Digital-Wandlern können die normierten Zeitversätze $\varepsilon_i$ bzw. $\varepsilon_j$ gemäß Gleichung (1A) bzw. (1B) in die jeweiligen Übertragungsfunktionen $H_i(f)$ bzw. $H_j(f)$ integriert werden.

$$\widetilde{H}_i(f) = H_i(f) \cdot e^{j 2\pi \cdot f \cdot \varepsilon_i \cdot T_A} \qquad (1A)$$

$$\widetilde{H}_j(f) = H_j(f) \cdot e^{j 2\pi \cdot f \cdot \varepsilon_j \cdot T_A} \qquad (1B)$$

Die Fehlanpassungen in den einzelnen parallel geschalteten Analog-Digital-Wandlern verursachen im Spektrum des abgetasteten Ausgangssignals unerwünschte Nebenlinien.

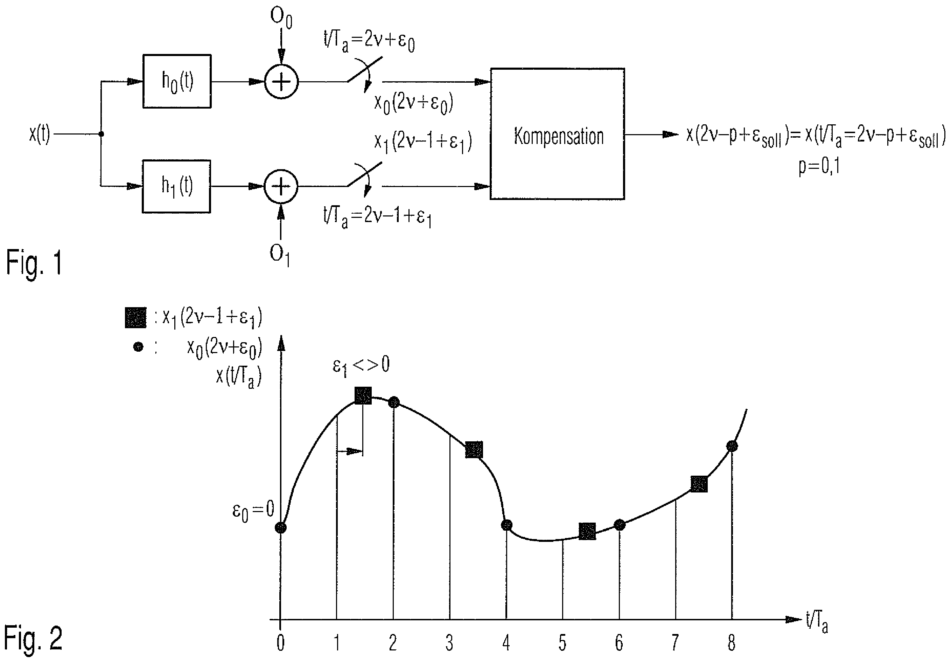

In Fig. 1 ist eine Parallelschaltung von zwei Analog-Digital-Wandlern dargestellt, die unterschiedliche Impulsantworten $h_0(t)$ bzw. $h_1(t)$, unterschiedliche Gleichanteile $o_0$ bzw. $o_1$ und unterschiedliche Zeitversätze $\varepsilon_0$ bzw. $\varepsilon_1$ aufweisen. Das am Eingang der beiden Analog-Digital-Wandler anliegende zeitkontinuierliche Eingangssignal $x(t)$ führt aufgrund der Fehlanpassungen in den beiden Analog-Digital-Wandlern zu Abtastwerten $x_0(2v+\varepsilon_0)$ bzw. $x_1(2v-1+\varepsilon_1)$ an den Ausgängen der beiden Analog-Digital-Wandler. Mittels einer digitalen Signalverarbeitung zur Kompensation der Fehlanpassungen in den Abtastwerten der Ausgangssignale der beiden A/D-Wandler werden aus den Abtastwerten $x_0(2v+\varepsilon_0)$ bzw.

$$x_1(2v - 1 + \varepsilon_1)$$

kompensierte Abtastwerte $x(2v-p+\varepsilon_{soll})$ mit $p=0,1$ am Ausgang der Kompensation erzeugt.

In Fig. 2 sind in einem Zeitdiagramm für eine derartige Parallelschaltung von zwei Analog-Digital-Wandlern die Abtastwerte $x_0(2v-\varepsilon_0)$ bzw. $x_1(2v-\varepsilon_1)$ der Ausgangssignale der beiden A/D-Wandler dargestellt. Unter der Prämisse, dass die Abtastzeitpunkte der Abtastwerte $x_0(2v-\varepsilon_0)$ des einen Analog-Digital-Wandlers als Referenz-Abtastzeitpunkte für die Parallelschaltung der beiden Analog-Digital-Wandler herangezogen werden, ist der Zeitversatz $\varepsilon_0$ für diese Abtastwerte, wie aus Fig. 2 zu erkennen ist, Null. Der Zeitversatz $\varepsilon_1$ der vom anderen Analog-Digital-Wandler erzeugten Abtastwerte $x_1(2v-\varepsilon_1)$ wird, wie ebenfalls aus Fig. 2 hervorgeht, auf diese Referenz-Abtastzeitpunkte referenziert und ist ungleich Null.

Aus der WO 2008/156400 A1 sind zur Kompensation von Fehlanpassungen in parallel geschalteten und zeitlich versetzt abtastenden A/D-Wandlern Kompensationsfilter bekannt. Die Impulsantworten dieser Kompensationsfilter werden hierbei über ein Verfahren zur Minimierung des Fehlers zwischen dem analogen Eingangssignal und dem zugehörigen abgetasteten Ausgangssignal der Serienschaltung aus Analog-Digital-Wandlern und Kompensationsfiltern ermittelt. Hierzu müssen in einer Vormessung die Übertragungsfunktionen der einzelnen Analog-Digital-Wandler ermittelt werden. Hierzu ist eine aufwendige Spektralmessung erforderlich.

Ferner ist aus "6 Wiener Filters" (In: Saeed V. Vaseghi: "Advanced Digital signal Processing and Noise Reduction", 1. Januar 2000, John Wiley & Sons Ltd., Seiten 178-204) ein Verfahren zur Kompensation von unterschiedlich zeitversetzten Signalen in einem Mehrkanal-Übertragungssystem bekannt.

Aufgabe der Erfindung ist es deshalb, ein Verfahren und eine Vorrichtung zur Kompensation von Fehlanpassungen - beschränkt im Folgenden auf Unterschiede in den Übertragungsfunktionen und in den Zeitversätzen - in parallel geschalteten und zeitlich versetzt abtastenden Analog-Digital-Wandlern zu schaffen, die keine aufwendige Spektralmessung der Übertragungsfunktionen der Analog-Digital-Wandler erfordert.

Die Erfindungsaufgabe wird durch ein Verfahren zur Kompensation von Fehlanpassungen zwischen mehreren jeweils zeitlich versetzt zueinander abtastenden Analog-Digital-Wandlern mit den Merkmalen des Patentanspruchs 1 und durch eine Vorrichtung zur Kompensation von Fehlanpassungen zwischen mehreren jeweils zeitlich versetzt zueinander abtastenden Analog-Digital-Wandlern mit den Merkmalen des Patentanspruchs 6 gelöst. Patentanspruch 7 bezieht sich auf ein entsprechendes Computerprogramm und Patentanspruch 8 bezieht sich auf ein entsprechendes Computerprogramm-Produkt. Die abhängigen Ansprüche enthalten vorteilhafte Weiterbildungen des Verfahrens.

Erfindungsgemäß erfolgt die Ermittlung des Übertragungsverhaltens der einzelnen Analog-Digital-Wandler nicht im Frequenzbereich, sondern im Zeitbereich, da Zeitbereichsmessungen typischerweise exakter und weniger aufwendig als Frequenzbereichsmessungen sind.

Hierzu wird die Autokorrelationsfunktion des abzutastenden Eingangssignals ermittelt. Aus der ermittelten Autokorrelationsfunktion und jeweils einer mittels einer Zeitbereichsmessung ermittelten Impulsantwort eines Analog-Digital-Wandlers wird jeweils eine erste Kreuzkorrelationsfunktion und aus der ermittelten Autokorrelationsfunktion und von jeweils zwei mittels einer Zeitbereichsmessung ermittelten Impulsantworten von jeweils zwei Analog-Digital-Wandlern wird jeweils eine zweite Kreuzkorrelationsfunktion ermittelt. Aus den ermittelten ersten und zweiten Kreuzkorrelationsfunktionen zu einzelnen Abtastzeitpunkten wird schließlich die Impulsantwort für jedes zu einem Analog-Digital-Wandler gehörige Kompensationsfilter bestimmt.

In einer ersten Ausführungsform der Erfindung werden in einem periodisch zeitvarianten Filter aus zyklisch zu berechnenden Kompensationsfiltern jedem einzelnen Kompensationsfilter die von beiden Analog-Digital-Wandlern erzeugten Abtastwerte zugeführt, wobei jedes einzelne Kompensationsfilter lediglich kompensierte Abtastwerte in einer zugehörigen Polyphase des abgetasteten Ausgangssignals liefert.

In einer zweiten Ausführungsform der Erfindung werden im Rahmen einer Synthesefilterbank die einzelnen zu jeweils einem Analog-Digital-Wandler gehörigen Kompensationsfilter parallel geschaltet und einzig von den Abtastwerten des zugehörigen Analog-Digital-Wandlers gespeist.

Da das Eingangssignal typischerweise unbekannt ist, wird als Näherung für das Eingangssignal eine Sinc-Funktion verwendet, also eine Funktion der Form sin(x)/x. Ist die Bandbreite des Eingangssignals bekannt, so wird die Bandbreite des zur Sinc-Funktion gehörigen rechteckförmigen Spektrums an die Bandbreite des Eingangssignals angepasst. Ist die Bandbreite des Eingangssignals dagegen nicht bekannt, so wird eine Bandbreite für das zur Sinc-Funktion gehörige rechteckförmige Spektrum eingestellt, deren maximale Frequenz typischerweise kleiner ist als die maximal zu erwartende Frequenz des Eingangssignals ist. Spektralanteile des Eingangssignals, die größer als die Bandbreite der Näherung sind, werden in diesem Fall nicht kompensiert.

Für den Fall, dass die einzelnen parallel geschalteten Analog-Digital-Wandler als Fehlanpassungen lediglich Zeitversätze zu den einzelnen normierten Abtastzeitpunkten, aber keine Unterschiede in den Übertragungsfunktionen aufweisen, sind die Impulsantworten der einzelnen Analog-Digital-Wandler identisch und weisen Dirac-Impuls auf. Die Faltung der Autokorrelationsfunktion mit einem Dirac-Impuls ergibt wiederum die Autokorrelationsfunktion, so dass die für die Faltung erforderliche numerische Berechnung eines Integrals nicht durchzuführen ist. Die Autokorrelationsfunktion des Eingangssignals ist in diesem Fall identisch zur ersten und zweiten Kreuzkorrelationsfunktion.

Die Ermittlung der Impulsantworten der einzelnen Kompensationsfilter erfordert die Invertierung einer höherrangigen Matrix. Um den numerischen Aufwand bei der Ermittlung der Impulsantworten möglichst zu minimieren, werden die Impulsantworten der einzelnen Kompensationsfilter für diskrete Werte des Zeitversatzes des zum jeweiligen Analog-Digital-Wandler jeweils gehörigen Kompensationsfilters zu den einzelnen normierten Abtastzeitpunkten in Relation zum Zeitversatz eines zu einem Referenz-Analog-Digital-Wandler gehörigen Kompensationsfilters zu den einzelnen normierten Abtastzeitpunkten vorab berechnet. In Echtzeit werden dann die Impulsantworten der einzelnen Kompensationsfilter für dazwischen liegende Zeitversätze mittels Interpolation, bevorzugt mittels linearer Interpolation, berechnet.

Ausführungsbeispiele des erfindungsgemäßen Verfahrens und der erfindungsgemäßen Vorrichtung zur Kompensation von Fehlanpassungen zwischen mehreren jeweils zeitlich versetzt zueinander abtastenden Analog-Digital-Wandlern werden im Folgenden anhand der Zeichnung im Detail erläutert. Die Figuren der Zeichnung zeigen:

Fig. 1    ein Blockdiagramm eines Gesamtsystems zur Verdeutlichung des der Erfindung zugrunde liegenden Problems,

Fig. 2    ein Zeitdiagramm einer Abtastung mit Zeitversatz,

Fig. 3    ein Blockdiagramm einer ersten Ausführungsform der erfindungsgemäßen Vorrichtung zur Kompensation von Fehlanpassungen zwischen mehreren jeweils zeitlich versetzt zueinander abtastenden Analog-Digital-Wandlern,

Fig. 4    ein Blockdiagramm einer zweiten Ausführungsform der erfindungsgemäßen Vorrichtung zur Kompensation von Fehlanpassungen zwischen mehreren jeweils zeitlich versetzt zueinander abtastenden Analog-Digital-Wandlern,

Fig. 5    ein Blockdiagramm für den Filterentwurf für die erste Ausführungsform der erfindungsgemäßen Vorrichtung,

Fig. 6    ein Blockdiagramm für den Filterentwurf für die zweite Ausführungsform der erfindungsgemäßen Vorrichtung und

Fig. 7    ein Flussdiagramm eines Ausführungsbeispiels des erfindungsgemäßen Verfahrens zur Kompensation von Fehlanpassungen zwischen mehreren jeweils zeitlich versetzt zueinander abtastenden Analog-Digital-Wandlern.

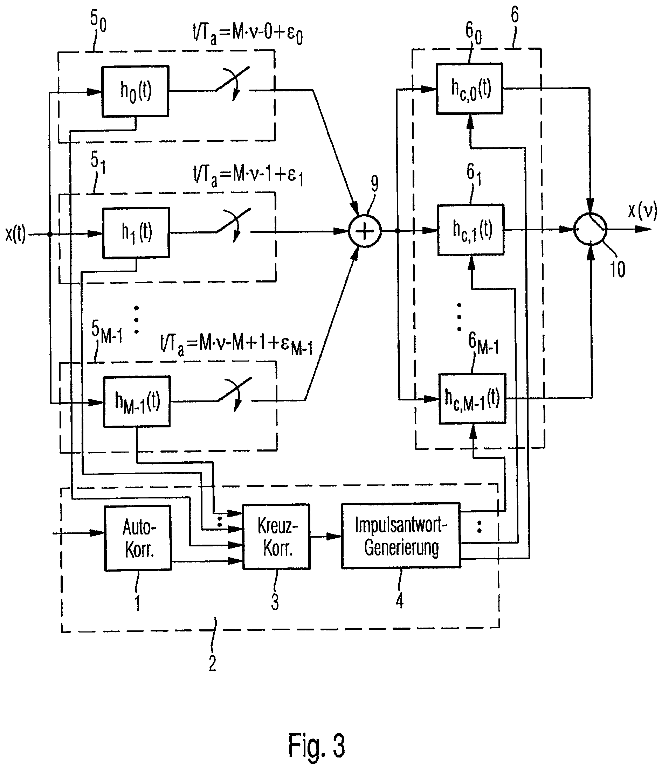

Bevor das erfindungsgemäße Verfahren und die erfindungsgemäße Vorrichtung zur Kompensation von Fehlanpassungen zwischen mehreren jeweils zeitlich versetzt zueinander abtastenden Analog-Digital-Wandlern anhand der Figuren 3, 4 und 7 im Detail erläutert werden, werden im Folgenden die für das Verständnis der Erfindung relevanten mathematischen Grundlagen hergeleitet.

Im ersten Schritt wird der Filterentwurf für eine Filterstruktur aus zyklisch zu berechnenden Kompensationsfiltern vorgestellt.

Der Filterentwurf basiert auf der Minimierung der Fehlerquadrate zwischen dem zeitdiskreten und fehlerkompensierten Ausgangssignal des aus Analog-Digital-Wandlern und Kompensationsfiltern bestehenden Gesamtsystems und dem Eingangssignal des Gesamtsystems, das ursprünglich zeitkontinuierlich ist und mittels einer Abtastung zeitdiskret wurde.

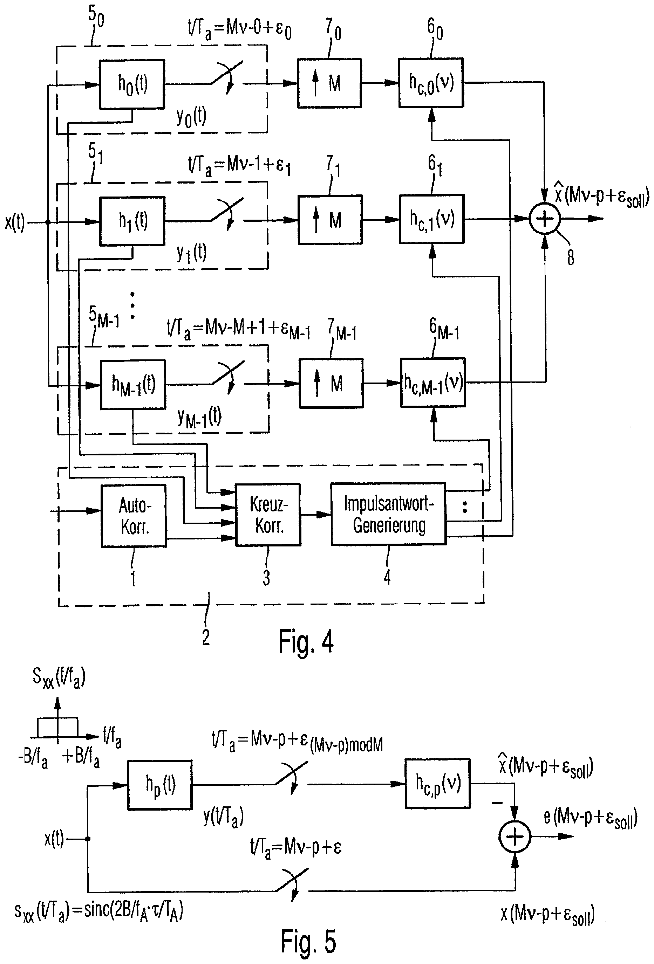

Bei der Filterstruktur aus zyklisch zu berechnenden Kompensationsfiltern werden, wie im zugehörigen Blockdiagramm zum Filterentwurf in Fig. 5 dargestellt ist, die Abtastwerte des zeitdiskreten Ausgangssignals des Gesamtsystems zyklisch aus den zeitdiskreten Abtastwerten der von den einzelnen Kompensationsfiltern jeweils erzeugten Ausgangssignale gebildet. Bei insgesamt $M$ Kompensationsfiltern ergibt sich nach insgesamt $v$ Zyklen beim Auslesen des Abtastwerts am $p$-ten Kompensationsfilter, der einen Referenz-Zeitversatz $\varepsilon_{soll}$ gegenüber dem normierten Abtastzeitpunkt $M \cdot v\text{-}p$ aufweist, der Abtastwert $\hat{x}(M \cdot v\text{-}p + \varepsilon_{soll})$ des zeitdiskreten Ausgangssignals des Gesamtsystems. Der Fehler $e(M \cdot v\text{-}p + \varepsilon_{soll})$ des Abtastwerts $\hat{x}(M \cdot v\text{-}p + \varepsilon_{soll})$ des Ausgangssignals ergibt sich gemäß Gleichung (1) aus der Differenz zum zugehörigen zeitdiskreten Eingangssignal $x(M \cdot v\text{-}p + \varepsilon_{soll})$ des Gesamtsystems. Der Abtastwert $\hat{x}(M \cdot v\text{-}p + \varepsilon_{soll})$ des zeitdiskreten Ausgangssignals des Gesamtsystems wiederum lässt sich aus den insgesamt $L$ Abtastwerten $\underline{y}(M \cdot v\text{-}p + \varepsilon_{(M \cdot v\text{-}p) \bmod M})$ des zeitdiskreten Ausgangssignals des $p$-ten Analog-Digital-Wandlers im $v$-ten Zyklus multipliziert mit der Impulsantwort $\underline{h}^T_{c,p}$ des $p$-ten Kompensationsfilters ermitteln.

Die $L$ Abtastwerte $\underline{y}(M \cdot v\text{-}p + \varepsilon_{(M \cdot v\text{-}p) \bmod M})$ des zeitdiskreten Ausgangssignals des $p$-ten Analog-Digital-Wandlers sind für die Faltung im $p$-ten Kompensationsfilter mit der Filterlänge $L$ erforderlich und ergeben sich gemäß Gleichung (2) aus dem Abtastwert in der Polyphase $p$ im $v$-ten Zyklus und den jeweils $\frac{L-1}{2}$ rechts- und linksseitig dieser Polyphase $p$ befindlichen Abtastwerten. Hierbei ist der Zeitversatz $\varepsilon$ von Abtastwert zu Abtastwert unterschiedlich und weist eine Periodizität in Höhe von $M$ aufgrund der Tatsache auf, dass die von einem identischen Analog-Digital-Wandler erzeugten Abtastwerte jeweils einen identischen Zeitversatz aufweisen und die den einzelnen Kompensationsfiltern jeweils zugeführten Abtastwerte jeweils zyklisch von den insgesamt $M$ Analog-Digital-Wandlern abgeleitet werden.

$$e(M \cdot v - p + \varepsilon_{soll}) = x(M \cdot v - p + \varepsilon_{soll}) - \hat{x}(M \cdot v - p + \varepsilon_{soll}) =$$
$$= x(M \cdot v - p + \varepsilon_{soll}) - \underline{h}^T_{c,p} \cdot \underline{y}(M \cdot v - p) \tag{1}$$

$$\underline{y}(M \cdot v - p) = \Big[ y(M \cdot v - p + (L-1)/2 + \varepsilon_{(M \cdot v - p + (L-1)/2)\bmod M}), \dots$$
$$, y(M \cdot v - p + 1 + \varepsilon_{(M \cdot v - p + 1)\bmod M}), y(M \cdot v - p + \varepsilon_{(M \cdot v - p)\bmod M}),$$
$$, y(M \cdot v - p - 1 + \varepsilon_{(M \cdot v - p - 1)\bmod M}),$$
$$\dots, y(M \cdot v - p - (L-1)/2 + \varepsilon_{(M \cdot v - p - (L-1)/2)\bmod M}) \Big] \qquad (2)$$

Die Impulsantwort $\underline{h}^T_{c,p}$ des $p$-ten Kompensationsfilters ergibt sich bei einer Filterlänge $L$ gemäß Gleichung (3).

$$\underline{h}^T_{c,p} = \Big[ h_{c,p-(L-1)/2}, \dots, h_{c,p-1}, h_{c,p}, h_{c,p+1}, \dots, h_{c,p+(L-1)/2} \Big] \qquad (3)$$

Die Ermittlung der Impulsantwort $\underline{h}^T_{c,p}$ des $p$-ten Kompensationsfilters erfolgt unter Minimierung des mittleren quadratischen Fehlers. Der mittlere quadratische Fehler $E\{e^2(M \cdot v\text{-}p + \varepsilon_{soll})\}$ ergibt sich ausgehend von Gleichung (1) gemäß Gleichung (4).

$$E\{e^2(M \cdot v - p + \varepsilon_{soll})\} = \underline{h}^T_{c,p} \cdot E\{\underline{y}(M \cdot v - p) \cdot \underline{y}^T(M \cdot v - p)\} \cdot \underline{h}^T_{c,p}$$
$$- 2 \cdot E\{x(M \cdot v - p + \varepsilon_{soll}) \cdot \underline{y}^T(M \cdot v - p)\} \cdot \underline{h}^T_{c,p} + E\{x^2(M \cdot v - p + \varepsilon_{soll})\}$$
$$= \underline{h}^T_{c,p} \cdot A \cdot \underline{h}_{c,p} + \underline{b}^T \cdot \underline{h}_{c,p} + c \qquad (4)$$

mit

$$A = E\{\underline{y}(M \cdot v - p) \cdot \underline{y}^T(M \cdot v - p)\},$$
$$\underline{b}^T = -2 \cdot E\{x(M \cdot v - p + \varepsilon_{soll}) \cdot \underline{y}^T(M \cdot v - p)\},$$
$$c = E\{x^2(M \cdot v - p + \varepsilon_{soll})\}.$$

Die Minimierung des mittleren quadratischen Fehlers erfolgt durch Bildung der ersten Ableitung des mittleren quadratischen Fehlers $E\{e^2(M \cdot v\text{-}p + \varepsilon_{soll})\}$ nach der Impulsantwort $\underline{h}^T_{c,p}$ des $p$-ten Kompensationsfilters und Nullsetzen gemäß Gleichung (5).

$$\frac{\partial E\{e^2(M \cdot v - p + \varepsilon)\}}{\partial \underline{h}_{c,p}} = 2 \cdot A \cdot \underline{h}_{c,p} + \underline{b} = 0 \qquad (5)$$

Die Impulsantwort $\underline{h}_{c,p}$ des $p$-ten Kompensationsfilters lässt sich somit gemäß Gleichung (6) berechnen.

$$\underline{h}_{c,p} = -\frac{1}{2} \cdot A^{-1} \cdot \underline{b} \qquad (6)$$

Für die Berechnung der Hilfsgröße $\underline{b}$ sind Abtastwerte einer zeitkontinuierlichen ersten Kreuzkorrelationsfunktion $s_{xy_p}(\tau/T_A)$ für unterschiedliche Abtastzeitpunkte $\tau/T_A$ aus der zeitkontinuierlichen Impulsantwort $h_p(t/T_A)$ des $p$-ten Analog-Digital-Wandlers und der zeitkontinuierlichen Autokorrelationsfunktion $s_{xx}(\tau/T_A)$ des Eingangssignals $x(t)$ gemäß Gleichung (7) heranzuziehen.

$$s_{xy_p}(\tau/T_A) = E\{x(t/T_A) \cdot y(t/T_A + \tau/T_A)\} = \int_{-\infty}^{+\infty} h_p(\zeta) \cdot s_{xx}(\tau/T_A - \zeta)d\zeta \qquad (7)$$

Für die Berechnung der Hilfsgröße $A$ sind Abtastwerte einer zeitkontinuierlichen zweiten Kreuzkorrelationsfunktion $s_{y_iy_j}(\tau/T_A)$ für unterschiedliche Abtastzeitpunkte $\tau/T_A$ aus der zeitkontinuierlichen Impulsantwort $h_{p_i}(t/T_A)$ des

$p_j$-ten Analog-Digital-Wandlers und der zeitkontinuierlichen Impulsantwort $h_{pj}(t/T_A)$ des $p_j$-ten Analog-Digital-Wandlers und der zeitkontinuierlichen Autokorrelationsfunktion $s_{xx}(\tau/T_A)$ des Eingangssignals $x(t)$ gemäß Gleichung (8) zu berechnen.

$$s_{y_i y_j}(\tau/T_A) = E\left\{y_i(t/T_A) \cdot y_j(t/T_A + \tau/T_A)\right\} =$$
$$= \int\limits_{-\infty}^{+\infty} \int\limits_{-\infty}^{+\infty} h_i(\zeta_0) \cdot h_j(\zeta_1) \cdot s_{xx}(\tau/T_A + \zeta_0 - \zeta_1) d\zeta_0 d\zeta_1 \qquad (8)$$

Bei unbekanntem Eingangssignal $x(t)$ wird die zeitkontinuierliche Autokorrelationsfunktion $s_{xx}(\tau/T_A)$ des Eingangssignals $x(t)$ durch eine sinc-Funktion gemäß Gleichung (9) mit einer Bandbreite $B$ genähert. Ist die Bandbreite des Eingangssignals $x(t)$ bekannt, so wird die Bandbreite $B$ der sinc-Funktion an die Bandbreite des Eingangssignals $x(t)$ angepasst. Ist die Bandbreite des Eingangssignals $x(t)$ dagegen unbekannt, so wird eine Bandbreite $B$ der sinc-Funktion eingestellt, die gegenüber der maximal zu erwartenden Frequenz des Eingangssignals reduziert ist. In diesem Fall werden die Spektralanteile des Eingangssignals oberhalb der Bandbreite der Näherung nicht kompensiert.

$$s_{xx}(\tau/T_A) = \frac{\sin(\pi \cdot 2B/f_A \cdot \tau/T_A)}{\pi \cdot 2B/f_A \cdot \tau/T_A} \qquad (9)$$

Im zweiten Schritt wird nun der Filterentwurf für eine Filterbank aus Kompensationsfiltern vorgestellt.

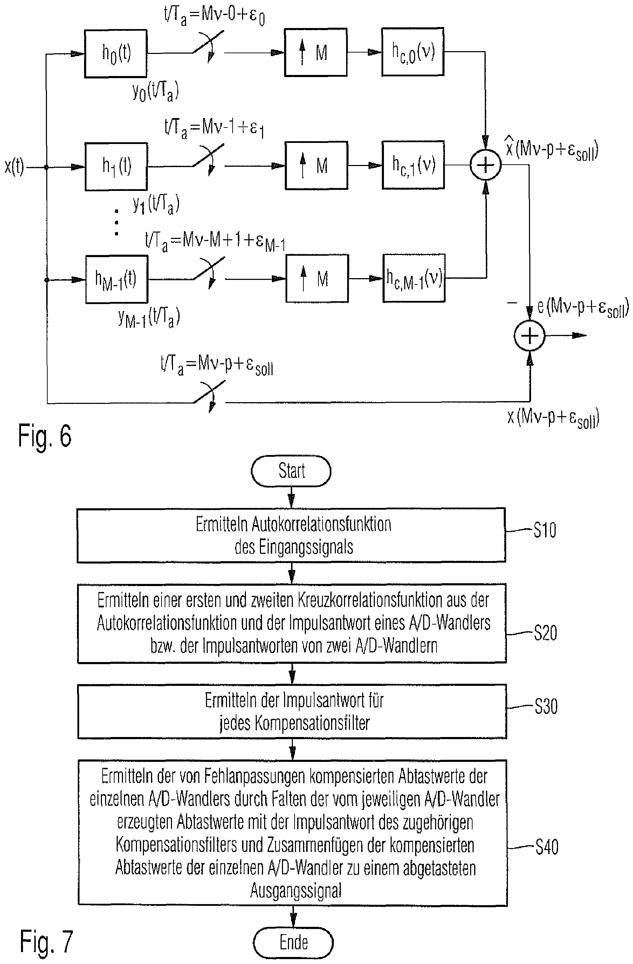

Der Fehler $e(M \cdot v - p + \varepsilon_{soll})$ des Abtastwerts $\hat{x}(M \cdot v - p + \varepsilon_{soll})$ des Ausgangssignals der Kompensationsfilter für den Fall einer aus Kompensationsfiltern bestehenden Filterbank ergibt sich gemäß Gleichung (10) und dem Blockdiagramm für den Filterentwurf gemäß Fig. 6.

$$e(M \cdot v - p + \varepsilon_{soll}) = x(M \cdot v - p + \varepsilon_{soll}) - \hat{x}(M \cdot v - p + \varepsilon_{soll}) =$$
$$= x(M \cdot v - p + \varepsilon_{soll}) - \underline{h}^T_{c,p} \cdot \underline{y}(M \cdot v) \qquad (10)$$

Der Vektor mit den Impulsantworten $\underline{h}^T_{c,p}$ der einzelnen Kompensationsfilter $i = 0,1,...,M$-1 ergibt sich aus Gleichung (11). Der Vektor der Impulsantworten $\underline{h}_{c,i,p}$ für ein einzelnes Kompensationsfilter $i$ und für eine bestimmte Polyphase $p$ ist Gleichung (12) zu entnehmen. Der Vektor der Impulsantworten $\underline{h}_{c,i,p}$ für ein einzelnes Kompensationsfilter $i$ weist für die Faltung mit den Abtastwerten $\underline{y}_i(M \cdot v)$ am Ausgang des zugehörigen Analog-Digital-Wandlers $i$ eine der Filterlänge $L$ des Kompensationsfilters $i$ entsprechende Anzahl Impulsantworten auf, die links- und rechtsseitig um die gewählte Polyphase $p$ gleichverteilt angeordnet sind.

$$\underline{h}^T_{c,p} = \left[\underline{h}^T_{c,0,p}, \underline{h}^T_{c,1,p}, \cdots, \underline{h}^T_{c,i,p}, \cdots, \underline{h}^T_{c,M-1,p}\right]^T \qquad (11)$$

mit

$$\underline{h}_{c,i,p} = \left[\ldots, h_{c,i,-2 \cdot M+p}, h_{c,i,-1 \cdot M+p}, h_{c,i,p}, h_{c,i,+1 \cdot M+p}, h_{c,i,+2 \cdot M+p}, \cdots\right]$$
$$(12)$$

Analog ergibt sich der Vektor $\underline{y}(M \cdot v)$ mit den Abtastwerten der Ausgangssignale $\underline{y}_i^T(M \cdot v)$ an den einzelnen Analog-Digital-Wandlern $i=0,1,...,M$-1 gemäß Gleichung (13).

$$\underline{y}(M \cdot v) = \left[ \underline{y}_0^{\ T}(M \cdot v), .., \underline{y}_i^{\ T}(M \cdot v), .., \underline{y}_{M-1}^{\ T}(M \cdot v) \right]$$

$$(13)$$

Der Vektor $\underline{y}_i^{\ T}(M \cdot v - p)$ mit den Abtastwerten des Ausgangssignals am Analog-Digital-Wandler *i*, der für die Faltung mit den entsprechenden Abtastwerten der Impulsantwort $\underline{h}_{c,i,p}$ des Kompensationsfilters *i* eine der Filterlänge *L* des Kompensationsfilters *i* entsprechende Anzahl von Elementen aufweist, ist Gleichung (14) zu entnehmen.

$$\underline{y}_i^{\ T}(M \cdot v) = \Big[ ..., y_i(M \cdot v - i + \varepsilon_{(M \cdot v - i - 2 \cdot M) \bmod M} - 2 \cdot M),$$
$$y_i(M \cdot v - i + \varepsilon_{(M \cdot v - i - 1 \cdot M) \bmod M} - 1 \cdot M), y_i(M \cdot v - i + \varepsilon_{(M \cdot v - i) \bmod M}),$$
$$y_i(M \cdot v - i + \varepsilon_{(M \cdot v - i + 1 \cdot M) \bmod M} + 1 \cdot M), y_i(M \cdot v - i + \varepsilon_{(M \cdot v - i + 2 \cdot M) \bmod M} + 2 \cdot M), ... \Big]$$

$$(14)$$

Die Ermittlung der Impulsantwort $\underline{h}^T_{c,p}$ des *p*-ten Kompensationsfilters erfolgt unter Minimierung des mittleren quadratischen Fehlers. Der mittlere quadratische Fehler $E\{e^2(M \cdot v - p + \varepsilon_{soll})\}$ ergibt sich ausgehend von Gleichung (10) gemäß Gleichung (15).

$$E\left\{ e^2(M \cdot v - p + \varepsilon_{soll}) \right\} = \underline{h}^T_{c,p} \cdot E\left\{ \underline{y}(M \cdot v) \cdot \underline{y}^T(M \cdot v) \right\} \cdot \underline{h}^T_{c,p}$$
$$-2 \cdot E\left\{ x(M \cdot v - p + \varepsilon_{soll}) \cdot \underline{y}^T(M \cdot v) \right\} \cdot \underline{h}^T_{c,p} + E\left\{ x^2(M \cdot v - p + \varepsilon_{soll}) \right\}$$
$$= \underline{h}^T_{c,p} \cdot A' \cdot \underline{h}_{c,p} + \underline{b}'^T \cdot \underline{h}_{c,p} + c' \qquad (15)$$

mit

$$A' = E\left\{ \underline{y}(M \cdot v) \cdot \underline{y}^T(M \cdot v) \right\},$$

$$\underline{b}'^T = -2 \cdot E\left\{ x(M \cdot v - p + \varepsilon_{soll}) \cdot \underline{y}^T(M \cdot v) \right\},$$
$$c' = E\left\{ x^2(M \cdot v - p + \varepsilon_{soll}) \right\}.$$

Die Minimierung des mittleren quadratischen Fehlers erfolgt durch Bildung der ersten Ableitung des mittleren quadratischen Fehlers $E\{e^2(M \cdot v - p + \varepsilon_{soll})\}$ nach der Impulsantwort $\underline{h}_{c,p}$ des *p*-ten Kompensationsfilters und Nullsetzen gemäß Gleichung (16).

$$\frac{\partial E\left\{ e^2(M \cdot v - p + \varepsilon) \right\}}{\partial \underline{h}_{c,p}} = 2 \cdot A' \cdot \underline{h}_{c,p} + \underline{b}' = 0 \qquad (16)$$

Die Impulsantwort $\underline{h}_{c,p}$ des *p*-ten Kompensationsfilters ergibt sich somit gemäß Gleichung (17).

$$\underline{h}_{c,p} = -\frac{1}{2} \cdot A'^{-1} \cdot \underline{b}' \qquad (17)$$

Für die Berechnung der Hilfsgröße *b'* sind Abtastwerte einer zeitkontinuierlichen ersten Kreuzkorrelationsfunktion $s_{xy_p}(\tau/T_A)$ für unterschiedliche Abtastzeitpunkte $\tau/T_A$ aus der zeitkontinuierliche Impulsantwort $h_p(t/T_A)$ des *p*-ten Analog-Digital-Wandlers und der zeitkontinuierliche Autokorrelationsfunktion $s_{xx}(\tau/T_A)$ des Eingangssignals $x(t)$ gemäß Gleichung (7) zu berechnen.

Für die Berechnung der Hilfsgröße $A'$ sind Abtastwerte einer zeitkontinuierlichen zweiten Kreuzkorrelationsfunktion $s_{y_iy_j}(\tau/T_A)$ für unterschiedliche Abtastzeitpunkte $\tau/T_A$ aus der zeitkontinuierlichen Impulsantwort $h_{p_i}(t/T_A)$ des $p_i$-ten Analog-Digital-Wandlers und der zeitkontinuierlichen Impulsantwort $h_{p_j}(t/T_A)$ des $p_j$-ten Analog-Digital-Wandlers und der zeitkontinuierlichen Autokorrelationsfunktion $s_{xx}(\tau/T_A)$ des Eingangssignals $x(t)$ gemäß Gleichung (8) zu berechnen.

Bei unbekanntem Eingangssignal $x(t)$ wird die zeitkontinuierlichen Autokorrelationsfunktion $s_{xx}(\tau/T_A)$ des Eingangssignals $x(t)$ durch eine sinc-Funktion gemäß Gleichung (9) mit einer Bandbreite $B$ genähert.

Die Invertierung der Matrix $A$ in Gleichung (6) und der Matrix $A'$ in Gleichung (17) ist aufgrund des hohen Ranges in Echtzeit numerisch sehr aufwendig zu berechnen. Eine Vereinfachung ergibt sich, wenn die Übertragungsfunktionen zwischen den einzelnen Analog-Digital-Wandlern identisch sind und lediglich unterschiedliche Zeitversätze zu berücksichtigen sind.

Die Vorgehensweise wird im Folgenden für den Sonderfall von zwei parallel geschalteten Analog-Digital-Wandlern erläutert. Die Vorgehensweise ist für eine höhere Anzahl von parallel geschalteten Analog-Digital-Wandlern analog anwendbar und von der Erfindung ebenfalls mit abgedeckt.

Wählt man einen Analog-Digital-Wandler als Referenz, so stellen dessen Abtastzeitpunkte Referenz-Abtastzeitpunkte für die Abtastzeitpunkte des anderen Analog-Digital-Wandler dar. Der Zeitversatz $\varepsilon_0$ dieses als Referenz dienenden Analog-Digital-Wandlers ist somit Null, während die Zeitversätze $\varepsilon_1$ des zweiten Analog-Digital-Wandlers in Relation zum Zeitversatz $\varepsilon_0$ dieses als Referenz dienenden Analog-Digital-Wandlers gesetzt werden.

Liegen dieser Zeitversätze $\varepsilon_1$ typischerweise in einem bestimmten Wertebereich, so werden vorab für eine bestimmte Anzahl $N$ von äquidistant beabstandeten Werten $\varepsilon_{1,j}$ (mit $j=1,...,N$) des Zeitversatzes $\varepsilon_1$ zugehörige Impulsantworten $h_{c,1,j}(v)$ vorab gemäß Gleichung (6) bzw. Gleichung (17) berechnet und abgespeichert. Für dazwischen liegende Zeitversätze $\varepsilon_1$ wird dann in Echtzeit mittels linearer Interpolation gemäß Gleichung (21) der exakte Wert für die Impulsantwort $h_{c,1}(v)$ aus den links- und rechtsseitig direkt benachbarten und vorab ermittelten und gespeicherten Werten der Impulsantwort $h_{c,1,links}(v)$ bzw. der Impulsantwort $h_{c,1,rechts}(v)$ sowie den zugehörigen Zeitversätzen $\varepsilon_{1,links}$ bzw. $\varepsilon_{1,rechts}$ gemäß Gleichung (18) bestimmt.

$$h_{c,1}(v) = h_{c,1,links}(v) + (\varepsilon_1 - \varepsilon_{1,links}) \cdot \frac{h_{c,1,rechts}(v) - h_{c,1,links}(v)}{\varepsilon_{1,rechts} - \varepsilon_{1,links}} \qquad (18)$$

Im Folgenden wird das erfindungsgemäße Verfahren zur Kompensation von Fehlanpassungen zwischen mehreren jeweils zeitlich versetzt zueinander abtastenden Analog-Digital-Wandlern anhand des Flussdiagramms in Fig. 7 in Kombination mit den beiden Ausführungsformen der erfindungsgemäßen Vorrichtung zur Kompensation von Fehlanpassungen zwischen mehreren jeweils zeitlich versetzt zueinander abtastenden Analog-Digital-Wandlern in den Figuren 3 und 4 im Detail erläutert.

Im ersten Verfahrensschritt S10 wird in einer Einheit 1 zum Ermitteln einer Autokorrelationsfunktion eines durch die Analog-Digital-Wandler abzutastenden Eingangssignals, die in einer übergeordneten Rechner-Einheit 2 integriert ist, die zeitkontinuierliche Autokorrelationsfunktion $s_{xx}(\tau/T_A)$ des Eingangssignals $x(t)$ gemäß Gleichung (8) bestimmt.

Da das Eingangssignal $x(t)$ typischerweise nicht bekannt ist, wird als zeitkontinuierliche Autokorrelationsfunktion $s_{xx}(\tau/T_A)$ des Eingangssignals $x(t)$ eine Sinc-Funktion gemäß Gleichung (9) verwendet, deren Bandbreite $B$ bei bekannter Bandbreite des Eingangssignals $x(t)$ der bekannten Bandbreite des Eingangssignals $x(t)$ entspricht und bei unbekannter Bandbreite des Eingangssignals $x(t)$ gegenüber der maximal zu erwartenden Frequenz des Eingangssignals $x(t)$ reduziert ist.

Im nächsten Verfahrensschritt S20 werden in einer Einheit 3 zum Ermitteln von ersten und zweiten Kreuzkorrelationsfunktionen für jeden einzelnen Analog-Digital-Wandler $5_0, 5_1,...,5_{M-1}$, die ebenfalls in der übergeordneten Rechner-Einheit 2 integriert ist, gemäß Gleichung (7) jeweils eine zeitkontinuierliche erste Korrelationsfunktion $s_{xy_p}(\tau/T_A)$ aus der zum jeweiligen Analog-Digital-Wandler $5_0, 5_1,...,5_{M-1}$ gehörigen zeitkontinuierlichen Impulsantwort $h_p(t/T_A)$ mit $p=0,1,...,M$-1 und der ermittelten zeitkontinuierlichen Autokorrelationsfunktion $s_{xx}(\tau/T_A)$ des Eingangssignals $x(t)$ und für jedes Paar von jeweils zwei Analog-Digital-Wandlern $5_0, 5_1, ..., 5_{M-1}$ und gemäß Gleichung (8) jeweils eine zeitkontinuierliche zweite Kreuzkorrelationsfunktion $s_{y_iy_j}(\tau/T_A)$ aus zwei zu verschiedenen Analog-Digital-Wandlern $5_0, 5_1, ..., 5_{M-1}$ jeweils gehörigen zeitkontinuierlichen Impulsantworten $h_{p_i}(t/T_A)$ und $h_{p_j}(t/T_A)$ mit $p_i=0,1,...,M$-1 bzw. $p_j=0,1,...,M$-1 und der ermittelten zeitkontinuierlichen Autokorrelationsfunktion $s_{xx}(\tau/T_A)$ des Eingangssignals $x(t)$ ermittelt.

Sind die Impulsantworten $h_p(t/T_A)$ bzw. $h_{p_i}(t/T_A)$ und $h_{p_j}(\tau/T_A)$ der einzelnen Analog-Digital-Wandler $5_0, 5_1,...,5_{M-1}$, die typischerweise Dirac-Impulse darstellen, identisch (keine Fehlanpassungen in den Übertragungsfunktionen), so ergibt die für die Berechnung der zeitkontinuierlichen ersten und zweiten Kreuzkorrelationsfunktion $s_{xy_p}(\tau/T_A)$ und $s_{y_iy_j}(\tau/T_A)$ gemäß Gleichung (7) und (8) erforderliche Faltung der zeitkontinuierlichen Impulsantwort (en) $h_p(t/T_A)$

bzw. $h_{pi}(t/T_A)$ und $h_{pj}(t/T_A)$ der einzelnen Analog-Digital-Wandler $5_0,5_1,...,5_{M-1}$, mit der zeitkontinuierlichen Autokorrelationsfunktion $s_{xx}(\tau/T_A)$ des Eingangssignals $x(t)$ wiederum die zeitkontinuierliche Autokorrelationsfunktion $s_{xx}(\tau/T_A)$ des Eingangssignals $x(t)$. Die zeitkontinuierliche erste und zweite Kreuzkorrelationsfunktion $s_{xy_p}(\tau/T_A)$ und $s_{y_iy_j}(\tau/T_A)$ entspricht also in diesem Fall der zeitkontinuierlichen Autokorrelationsfunktion $s_{xx}(\tau/T_A)$ des Eingangssignals $x(t)$ und die für die Faltung erforderliche numerische Integration muss in diesem Fall nicht durchgeführt werden.

Im nächsten Verfahrensschritt S30 werden in einer Einheit 4 zum Ermitteln einer Impulsantwort für jedes zu jeweils einem Analog-Digital-Wandler gehörige Kompensationsfilter die Koeffizienten der Matrizen $A$ bzw. $A'$ gemäß Gleichung (4) bzw. (15) mit den im vorherigen Verfahrensschritt S20 ermittelten zeitkontinuierlichen zweiten Kreuzkorrelationsfunktionen $s_{y_iy_j}(\tau/T_A)$ jeweils zu den einzelnen Abtastzeitpunkten $\dfrac{\tau}{T_A}$ ermittelt. Anschließend erfolgt die Invertierung der Matrizen $A$ bzw. $A'$ mit einem gängigen numerischen Verfahren. Die Bestimmung der im vorherigen Verfahrensschritt S20 ermittelten zeitkontinuierlichen ersten Kreuzkorrelationsfunktionen $s_{xy_p}(\tau/T_A)$ jeweils zu den einzelnen Abtastzeitpunkten $\dfrac{\tau}{T_A}$. ergibt die Vektoren $\underline{b}$ bzw. $\underline{b}'$. Schließlich werden die Impulsantworten $\underline{h}_{c,p}$ für alle Kompensationsfilter $6_0,6_1,...,6_{M-1}$ mit $p=0,1,...,M-1$ gemäß Gleichung (6) bzw. (17) ermittelt.

Zur Reduktion des sehr hohen numerischen Rechenaufwands bei der Bestimmung der Impulsantworten $\underline{h}_{c,p}$ für alle Kompensationsfilter $6_0,6_1,...,6_{M-1}$ aus den zeitkontinuierlichen ersten Kreuzkorrelationsfunktionen $s_{xy_p}(\tau/T_A)$ zu den einzelnen Abtastzeitpunkten $\dfrac{\tau}{T_A}$ in Echtzeit, wird alternativ im Fall von identischen Übertragungsfunktionen der einzelnen Analog-Digital-Wandler $5_0,5_1,...,5_{M-1}$ nur für einige bestimmte äquidistant voneinander beabstandete Werte $\varepsilon_{i,j}$ des Zeitversatzes $\varepsilon_i$ eines Analog-Digital-Wandlers $5_i$ in Relation zum Zeitversatz $\varepsilon_0$ eines anderen als Referenz dienenden Analog-Digital-Wandlers $5_0$ innerhalb eines bestimmten Bereichs des Zeitversatzes die zugehörige Impulsantwort $h_{c,i,j}(v)$ des zugehörigen Kompensationsfilters $6_i$ vorab berechnet und abgespeichert.

Für den Sonderfall von zwei parallel geschalteten Analog-Digital-Wandlern $5_0$ und $5_1$ wird mittels linearer Interpolation gemäß Gleichung (18) in Echtzeit relativ aufwandsarm für einen dazwischenliegenden Zeitversatz $\varepsilon_1$ die zugehörige Impulsantwort $h_{c,1}(v)$ aus den links- und rechtsseitig direkt benachbarten Zeitversätzen $\varepsilon_{1,links}$ und $\varepsilon_{1,rechts}$ sowie den zugehörigen vorab berechneten Impulsantworten $h_{c,1,links}(v)$ und $h_{c,1,rechts}(v)$ berechnet.

Mit den auf diese Weise ermittelten Impulsantworten $\underline{h}_{c,p}$ für die Kompensationsfilter $6_0,6_1,...,6_{M-1}$ werden im abschließenden Verfahrensschritt S40 die von den einzelnen Analog-Digital-Wandlern $5_0,5_1,...,5_{M-1}$ erzeugten Abtastwerte $\underline{y}(M \cdot v)$ des zeitkontinuierlichen Eingangssignals $x(t)$ zur Kompensation der unterschiedlichen Übertragungsfunktionen und der unterschiedlichen Zeitversätze der einzelnen Analog-Digital-Wandler $5_0,5_1,...,5_{M-1}$ gefaltet.

In der ersten Ausführungsform der erfindungsgemäßen Vorrichtung zur Kompensation von Fehlanpassungen zwischen mehreren jeweils zeitlich versetzt zueinander abtastenden Analog-Digital-Wandlern in Fig. 3 werden über einen Multiplexer 9 die von allen Analog-Digital-Wandlern $5_0,5_1,...,5_{M-1}$ erzeugten Abtastwerte zu einer alle Abtastwerte enthaltenden Abtastwert-Folge $\underline{y}(M \cdot v - p)$ zusammengefügt. Diese die Abtastwerte von allen Analog-Digital-Wandlern $5_0,5_1,...,5_{M-1}$ enthaltende Abtastwert-Folge $\underline{y}(M \cdot v - p)$ wird allen Kompensationsfiltern $6_0,6_1,...,6_{M-1}$ zugeführt. Jedes Kompensationsfilter $6_0,6_1,...,6_{M-1}$ verarbeitet die von allen Analog-Digital-Wandlern $5_0,5_1,...,5_{M-1}$ in Summe erzeugte Abtastwert-Folge $\underline{y}(M \cdot v - p)$ im Hinblick auf die Kompensation.

In einem Multiplexer 10 werden die von den einzelnen Kompensationsfiltern $6_0,6_1,...,6_{M-1}$ jeweils kompensierten Abtastwerte zyklisch zu einer Abtastwert-Folge $\underline{h}^T_{c,p} \cdot \underline{y}(M \cdot v - p)$ am Ausgang der erfindungsgemäßen Vorrichtung zusammengefügt. Die Abtastratenerhöhung erfolgt in der ersten Ausführungsform der Erfindung folglich im Multiplexer. Anstelle der parallel geschalteten Kompensationsfilter $6_0,6_1,...,6_{M-1}$ kann die erste Ausführungsform der erfindungsgemäßen Vorrichtung auch ein einziges struktur- bzw. zeitvariantes Kompensationsfilter 6 verwenden, dessen Impulsantwort zyklisch die zu den einzelnen Kompensationsfiltern $6_0,6_1,...,6_{M-1}$ jeweils gehörige Impulsantwort $\underline{h}^T_{c,p}$ zugeschaltet wird.

In der zweiten Ausführungsform der erfindungsgemäßen Vorrichtung zur Kompensation von Fehlanpassungen zwischen mehreren jeweils zeitlich versetzt zueinander abtastenden Analog-Digital-Wandlern in Fig. 4 werden die von den einzelnen Analog-Digital-Wandlern $5_0,5_1,...,5_{M-1}$ jeweils erzeugten Abtastwerte $\underline{y}_i^T(M \cdot v - p)$ des zeitkontinuierlichen Eingangssignals $x(t)$ über jeweils einen Interpolator $7_0,7_1,...,7_{M-1}$, deren Interpolations-Faktor jeweils der Anzahl $M$ von parallel geschalteten Analog-Digital-Wandlern entspricht, direkt den jeweils zugeordneten Kompensationsfiltern $6_0,6_1,...,6_{M-1}$ zugeführt. Nach der Kompensation der in den einzelnen Analog-Digital-Wandlern $5_0,5_1,...,5_{M-1}$ jeweils

erzeugten Abtastwerte $\underline{y}_i^{\ T}(M \cdot v - p)$ des zeitkontinuierlichen Eingangssignals x(t) in der die einzelnen Kompensationsfilter $6_0, 6_1, ..., 6_{M-1}$ enthaltenden Synthesefilterbank werden die Abtastwerte $\underline{h}^T_{c,p} \cdot \underline{y}(M \cdot v)$ des kompensierten Ausgangssignals über einen Summierer 8 zusammengefügt. Die Interpolation in den Interpolatoren $7_0, 7_1, ..., 7_{M-1}$ dient in der ersten Ausführungsform der erfindungsgemäßen Vorrichtung der Abtastratenerhöhung.

Die Erfindung ist nicht auf die dargestellten Ausführungsformen und Varianten beschränkt. Von der Erfindung sind außer der Optimierung nach den minimalen Fehlerquadraten auch andere numerische Optimierungsverfahren zur Bestimmung der Filterkoeffizienten von Kompensationsfilter mit abgedeckt.

**Patentansprüche**

1.  Verfahren zur Kompensation von Unterschieden in Impulsantwort und Zeitversatz zwischen mehreren parallel geschalteten und jeweils zeitlich versetzt zueinander abtastenden Analog-Digital-Wandlern ($5_0, 5_1, ..., 5_{M-1}$) mit jeweils einer mittels Zeitbereichsmessung ermittelten zeitkontinuierlichen Impulsantwort, wobei jeder Analog-Digital-Wandler ($5_0, 5_1, ..., 5_{M-1}$) mit einem zugehörigen zyklisch zu berechnenden Kompensationsfilter ($6_0, 6_1, ..., 6_{M-1}$) mit einer gegebenen Filterlänge und einer zu ermittelnden zeitkontinuierlichen Impulsantwort verbunden ist, das Verfahren weist dabei folgende Schritte für jedes Kompensationsfilter ($6_0, 6_1, ..., 6_{M-1}$) auf:

    Zuführen der von dem Analog-Digital-Wandler erzeugten Abtastwerte ($\underline{y}(M \cdot v - p)$) eines Eingangssignals zu dem zugehörigen Kompensationsfilter ($6_0, 6_1, ..., 6_{M-1}$);
    Falten der vom Analog-Digital-Wandler ($5_0, 5_1, ..., 5_{M-1}$) erzeugten Abtastwerte ($\underline{y}(M \cdot v - p)$) mit den Abtastwerten der Impulsantwort ($\underline{h}^T_{c,p}; h_{c,1}(v)$) des Kompensationsfilter ($6_0, 6_1, ..., 6_{M-1}$);
    **dadurch gekennzeichnet,**
    **dass** für jedes Kompensationsfilter ($6_0, 6_1, ..., 6_{M-1}$) folgende Schritte zur Ermittlung der zeitkontinuierlichen Impulsantwort ($\underline{h}^T_{c,p}; h_{c,1}(v)$) durchgeführt werden:

    Ermitteln einer zeitkontinuierlichen Autokorrelationsfunktion ($s_{xx}(\tau/T_A)$) eines durch die mehreren Analog-Digital-Wandler ($5_0, 5_1, ..., 5_{M-1}$) abzutastenden Eingangssignals ($x(t)$);
    Ermitteln von Abtastwerten einer ersten zeitkontinuierlichen Kreuzkorrelationsfunktion ($s_{xy_p}(\tau/T_A)$) durch Multiplikation der zeitkontinuierlichen Autokorrelationsfunktion ($s_{xx}(\tau/T_A)$) mit der zeitkontinuierlichen Impulsantwort ($\underline{h}^T_{c,p}; h_{c,1}(v)$) des zugehörigen Analog-Digital-Wandlers ($5_0, 5_1, ..., 5_{M-1}$) über eine der Filterlänge entsprechende Anzahl der erzeugten Abtastwerte ($\underline{y}(M \cdot v - p)$);
    Ermitteln von Abtastwerten einer zweiten zeitkontinuierlichen Kreuzkorrelationsfunktion ($s_{y_iy_j}(\tau/T_A)$) durch Multiplikation der Autokorrelationsfunktion ($s_{xx}(\tau/T_A)$) mit dem Produkt aus der Impulsantwort ($h_p(t/T_A)$) des zugehörigen Analog-Digital-Wandlers ($5_0, 5_1, ..., 5_{M-1}$) und der Impulsantwort ($h_p(t/T_A)$) eines zweiten anderen der mehreren Analog-Digital-Wandler ($5_0, 5_1, ..., 5_{M-1}$) über eine der Filterlänge entsprechende Anzahl der erzeugten Abtastwerte ($\underline{y}(M \cdot v - p)$); und
    Ermitteln der Impulsantwort ($\underline{h}^T_{c,p}; h_{c,1}(v)$) des Kompensationsfilters ($6_0, 6_1, ..., 6_{M-1}$) basierend auf den ermittelten Abtastwerten der ersten und zweiten Kreuzkorrelationsfunktion ($s_{xy_p}(\tau/T_A), s_{y_iy_j}(\tau/TA)$), sowie entsprechendes Bestimmen der Filterkoeffizienten des Kompensationsfilters ($6_0, 6_1, ..., 6_{M-1}$).

2.  Verfahren zur Kompensation nach Anspruch 1,
    **dadurch gekennzeichnet,**
    **dass** dem zum jeweiligen Analog-Digital-Wandler ($5_0, 5_1, ..., 5_{M-1}$) gehörigen Kompensationsfilter ($6_0, 6_1, ..., 6_{M-1}$) die von allen Analog-Digital-Wandlern ($5_0, 5_1, ..., 5_{M-1}$) erzeugten Abtastwerte ($\underline{y}(M \cdot v - p)$) des Eingangssignals ($x(t)$) zugeführt werden, wobei die von allen Analog-Digital-Wandlern ($5_0, 5_1, ..., 5_{M-1}$) erzeugten Abtastwerte zu einer alle Abtastwerte enthaltenden Abtastwert-Folge ($\underline{y}(M \cdot v - p)$) zusammengefügt werden.

3.  Verfahren zur Kompensation nach Anspruch 1 oder 2,
    **dadurch gekennzeichnet,**
    **dass** für den Fall, dass das Eingangssignal ($x(t)$) unbekannt ist, als Autokorrelationsfunktion ($s_{xx}(\tau/T_A)$) statt des Eingangssignals ($x(t)$) eine Sinc-Funktion verwendet wird.

4.  Verfahren zur Kompensation nach Anspruch 3,
    **dadurch gekennzeichnet,**
    **dass** die Sinc-Funktion auf eine Bandbreite (B) bandbegrenzt ist, die der bekannten Bandbreite des Eingangssignals

($x(t)$) entspricht oder bei unbekannter Bandbreite des Eingangssignals ($x(t)$) gegenüber der maximal zu erwartenden Frequenz des Eingangssignals ($x(t)$) reduziert ist.

5. Verfahren zur Kompensation nach einem der Ansprüche 1 bis 4,
   **dadurch gekennzeichnet,**
   **dass** für den Fall, dass identische Übertragungsfunktionen der Analog-Digital-Wandler ($5_0,5_1,...,5_{M-1}$) vorliegen, für die Ermittlung der ersten und zweiten Kreuzkorrelationsfunktionen ($s_{xy_p}(\tau/T_A),s_{y_iy_j}(\tau/T_A)$) jeweils die Autokorrelationsfunktion ($s_{xx}(\tau/T_A)$) verwendet wird, falls einzig Zeitversätze ($\varepsilon_0,\varepsilon_1,...,\varepsilon_{M-1}$) zwischen den einzelnen Analog-Digital-Wandlern ($5_0,5_1,...,5_{M-1}$) unterschiedlich sind.

6. Vorrichtung zur Kompensation von Unterschieden in Impulsantwort und Zeitversatz zwischen mehreren parallel geschalteten und jeweils zeitlich versetzt zueinander abtastenden Analog-Digital-Wandlern ($5_0,5_1,...,5_{M-1}$) der Vorrichtung mit jeweils einer mittels Zeitbereichsmessung ermittelten zeitkontinuierlichen Impulsantwort, wobei jeder Analog-Digital-Wandler ($5_0,5_1,...,5_{M-1}$) mit einem zugehörigen zyklisch zu berechnenden Kompensationsfilter ($6_0,6_1,...,6_{M-1}$) der Vorrichtung mit einer gegebenen Filterlänge und einer zu ermittelnden zeitkontinuierlichen Impulsantwort verbunden ist,
   **dadurch gekennzeichnet,**
   **dass** die Vorrichtung zur Ermittlung der zu den einzelnen Kompensationsfiltern ($6_0,6_1,...,6_{M-1}$) jeweils gehörigen Impulsantworten ($\underline{h}^T_{c,p}$) zusätzlich aufweist:

   eine erste Einheit (1), die ausgebildet ist eine zeitkontinuierliche Autokorrelationsfunktion ($s_{xx}(\tau/T_A)$) eines durch die mehreren Analog-Digital-Wandler ($5_0,5_1,...,5_{M-1}$) abzutastenden Eingangssignals ($x(t)$) zu ermitteln,
   eine zweite Einheit (2), die ausgebildet ist Abtastwerte einer ersten zeitkontinuierlichen Kreuzkorrelationsfunktion
   ($s_{xy_p}(\tau/T_A)$) durch Multiplikation der zeitkontinuierlichen Autokorrelationsfunktion ($s_{xx}(\tau/T_A)$) mit der zeitkontinuierlichen Impulsantwort ($\underline{h}^T_{c,p};h_{c,1}(v)$) des zugehörigen Analog-Digital-Wandlers ($5_0,5_1,...,5_{M-1}$) über eine der Filterlänge entsprechende Anzahl der erzeugten Abtastwerte ($\underline{y}(M\cdot v\text{-}p)$) zu ermitteln, und
   eine dritte Einheit (3), die ausgebildet ist Abtastwerten einer zweiten zeitkontinuierlichen Kreuzkorrelationsfunktion
   ($s_{y_iy_j}(\tau/T_A)$) durch Multiplikation der Autokorrelationsfunktion ($s_{xx}(\tau/T_A)$) mit dem Produkt aus der Impulsantwort ($h_p(t/T_A)$) des zugehörigen Analog-Digital-Wandlers ($5_0,5_1,...,5_{M-1}$) und der Impulsantwort ($h_p(t/T_A)$) eines zweiten anderen der mehreren Analog-Digital-Wandler ($5_0,5_1,...,5_{M-1}$) über eine der Filterlänge entsprechende Anzahl der erzeugten Abtastwerte ($\underline{y}(M\cdot v\text{-}p)$), zu ermitteln, und wobei die Vorrichtung weiter dazu ausgebildet ist die Impulsantwort ($\underline{h}^T_{c,p};h_{c,1}(v)$) des Kompensationsfilters ($6_0,6_1,...,6_{M-1}$) auf den ermittelten Abtastwerten der ersten und zweiten Kreuzkorrelationsfunktion ($s_{xy_p}(\tau/T_A)$, $s_{y_iy_j}(\tau/T_A)$) basierend zu ermitteln, und wobei die Filterkoeffizienten des Kompensationsfilters ($6_0,6_1,...,6_{M-1}$) bestimmt werden.

7. Computerprogramm mit Programmcode-Mitteln, um alle Schritte gemäß einem der Ansprüche 1 bis 5 durchführen zu können, wenn das Programm auf einem Computer oder einem digitalen Signalprozessor ausgeführt wird.

8. Computerprogramm-Produkt mit insbesondere auf einem maschinenlesbaren Träger gespeicherten Programmcode-Mitteln, um alle Schritte gemäß einem der Ansprüche 1 bis 5 durchführen zu können, wenn das Programm auf einem Computer oder einem digitalen Signalprozessor ausgeführt wird.

**Claims**

1. Method for compensating for mismatches in impulse response and time offset between a plurality of analogue-to-digital converters ($5_0,5_1,...,5_{M-1}$) connected in parallel and sampling with a respective time offset, each with a time-continuous impulse response determined by means of measurement in the time domain, wherein each analogue-to-digital converter ($5_0,5_1,...,5_{M-1}$) is connected with an associated cyclically calculating compensating filter ($6_0,6_1,...,6_{M-1}$) with a given filter length and a time-continuous impulse response to be determined, the method comprising the following steps for each compensating filter ($6_0,6_1,...,6_{M-1}$):

   feeding of the sampled values ($\underline{y}(M\cdot v\text{-}p)$) of an input signal generated by the analogue-to-digital converter to the associated compensating filter ($6_0,6_1,...,6_{M-1}$);
   convolution of the sampled values ($\underline{y}(M\cdot v\text{-}p)$) generated by the analogue-to-digital converter ($5_0,5_1,...,5_{M-1}$) with the sampled values of the impulse response ($\underline{h}^T_{c,p};h_{c,1}(v)$) of the compensating filter ($6_0,6_1,...,6_{M-1}$);

**characterised in that**
the following steps are carried out for each compensating filter $(6_0, 6_1, ..., 6_{M-1})$ to determine the time-continuous impulse response $(\underline{h}^T_{c,p}; h_{c,1}(v))$:

determination of a time-continuous auto correlation function $(s_{xx}(\tau/T_A))$ of an input signal $(x(t))$ to be sampled by the plurality of analogue-to-digital converters $(5_0, 5_1, ..., 5_{M-1})$;
determination of sampled values of a first time-continuous cross correlation function $(s_{xy_p}(\tau/T_A))$ by multiplication of the time-continuous auto correlation function $(s_{xx}(\tau/T_A))$ with the time-continuous impulse response $(\underline{h}^T_{c,p}; h_{c,1}(v))$ of the associated analogue-to-digital converter $(5_0, 5_1, ..., 5_{M-1})$ over a number of the generated sampled values $(\underline{y}(M \cdot v\text{-}p))$ corresponding to the filter length;
determination of sampled values of a second time-continuous cross correlation function $(s_{y_iy_j}(\tau/T_A))$ by multiplication of the auto correlation function $(s_{xx}(\tau/T_A))$ with the product of the impulse response $(h_p(t/T_A))$ of the associated analogue-to-digital converter $(5_0, 5_1, 5_{M-1})$ and the impulse response $(h_p(t/T_A))$ of a second other one of the plurality of analogue-to-digital converters $(5_0, 5_1, ..., 5_{M-1})$ over a number of the generated sampled values $(\underline{y}(M \cdot v\text{-}p))$ corresponding to the filter length; and
determination of the impulse response $(\underline{h}^T_{c,p}; h_{c,1}(v))$ of the compensating filter $(6_0, 6_1, ..., 6_{M-1})$ based on the determined sampled values of the first and second cross correlation function $(s_{xy_p}(\tau/T_A), s_{y_iy_j}(\tau/T_A))$, and respective definition of the filter coefficients of the compensating filter $(6_0, 6_1, ..., 6_{M-1})$.

2. Method for compensating according to claim 1,
**characterised in that**
the sampled values $(\underline{y}(M \cdot v\text{-}p))$ of the input signal $(x(t))$ generated by all the analogue-to-digital converters $(5_0, 5_1, ..., 5_{M-1})$ are fed to the compensating filter $(6_0, 6_1, ..., 6_{M-1})$ associated with the respective analogue-to-digital converter $(5_0, 5_1, ..., 5_{M-1})$, the sampled values generated by all the analogue-to-digital converters $(5_0, 5_1, 5_{M-1})$ being combined together to form a sequence of sampled values $(\underline{y}(M \cdot v\text{-}p))$ containing all the sampled values.

3. Method for compensating according to claim 1 or 2,

**characterised in that**
if the input signal $(x(t))$ is unknown, a sinc function is used as auto correlation function $(s_{xx}(\tau/T_A))$ instead of the input signal $(x(t))$.

4. Method for compensating according to claim 3, **characterised in that**
the sinc function is band-limited to a band width $(B)$ which corresponds to the known band width of the input signal $(x(t))$ or is reduced compared to the maximum expected frequency of the input signal $(x(t))$ when the band width of the input signal $(x(t))$ is unknown.

5. Method for compensating according to one of claims 1 to 4,
**characterised in that**
if identical transfer functions of the analogue-to-digital converters $(5_0, 5_1, ..., 5_{M-1})$ are present, the auto correlation function $(s_{xx}(\tau/T_A))$ is used in each case to determine the first and second cross correlation functions $(s_{xy_p}(\tau/T_A), s_{y_iy_j}(\tau/T_A))$ if individual time offsets $(\varepsilon_0, \varepsilon_1, ..., \varepsilon_{M-1})$ between the individual analogue-to-digital converters $(5_0, 5_1, ..., 5_{M-1})$ are different.

6. Device for compensating for mismatches in impulse response and time offset between a plurality of analogue-to-digital converters $(5_0, 5_1, 5_{M-1})$ of the device connected in parallel and sampling with a respective time offset, each with a time-continuous impulse response determined by means of measurement in the time domain, wherein each analogue-to-digital converter $(5_0, 5_1, ..., 5_{M-1})$ is connected with an associated cyclically calculating compensating filter $(6_0, 6_1, ..., 6_{M-1})$ of the device with a given filter length and a time-continuous impulse response,
**characterised in that**
to determine the impulse responses $(\underline{h}^T_{c,p})$ associated with each of the individual compensating filters $(6_0, 6_1, ..., 6_{M-1})$, the device additionally comprises:

a first unit (1) which is designed to determine a time-continuous auto correlation function $(s_{xx}(\tau/T_A))$ of an input signal $(x(t))$ to be sampled by the plurality of analogue-to-digital converters $(5_0, 5_1, ..., 5_{M-1})$,
a second unit (2) which is designed to determine sampled values of a first time-continuous cross correlation function $(s_{xy_p}(\tau/T_A))$ by multiplication of the time-continuous auto correlation function $(s_{xx}(\tau/T_A))$ with the time-continuous impulse response $(\underline{h}^T_{c,p}; h_{c,1}(v))$ of the associated analogue-to-digital converter $(5_0, 5_1, ..., 5_{M-1})$ over a number of the generated sampled values ($\underline{y}(M \cdot v\text{-}p)$) corresponding to the filter length, and
a third unit (3) which is designed to determine sampled values of a second time-continuous cross correlation function ($s_{y_iy_j}(\tau/T_A)$) by multiplication of the auto correlation function ($s_{xx}(\tau/T_A)$) with the product of the impulse response ($h_p(t/T_A)$) of the associated analogue-to-digital converter ($5_0,5_1,5_{M\text{-}1}$) and the impulse response ($h_p(t/T_A)$) of a second other one of the plurality of analogue-to-digital converters ($5_0,5_1,...,5_{M\text{-}1}$) over a number of the generated sampled values ($\underline{y}(M \cdot v\text{-}p)$) corresponding to the filter length, and wherein the device is also designed to determine the impulse response ($\underline{h}^T{}_{c,p};h_{c,1}(v)$) of the compensating filter ($6_0,6_1,...,6_{M\text{-}1}$) based on the determined sampled values of the first and second cross correlation function ($s_{xy_p}(\tau/T_A)$, $s_{y_iy_j}(\tau/T_A)$), and wherein the filter coefficients of the compensating filter ($6_0,6_1,...,6_{M\text{-}1}$) are defined.

7. Computer programme with programme code means in order to be able to carry out all the steps according to one of claims 1 to 5 when the programme is executed on a computer or a digital signal processor.

8. Computer programme product with in particular programme code means stored on a machine-readable medium in order to be able to carry out all the steps according to one of claims 1 to 5 when the programme is executed on a computer or a digital signal processor.

**Revendications**

1. Procédé de compensation de différences de réponse impulsionnelle et de décalage temporel entre plusieurs convertisseurs analogiques-numériques ($5_0,5_1,..., 5_{M\text{-}1}$) montés en parallèle et effectuant chacun un échantillonnage de façon décalée dans le temps les uns par rapport aux autres, présentant chacun une réponse impulsionnelle continue dans le temps établie au moyen d'une mesure de domaine temporel, dans lequel chaque convertisseur analogique-numérique ($5_0$, $5_1$, ..., $5_{M\text{-}1}$) est raccordé à un filtre de compensation ($6_0$, $6_1$, ..., $6_{M\text{-}1}$) associé à calculer de manière cyclique présentant une longueur de filtre donnée et une réponse impulsionnelle continue dans le temps à établir, le procédé comprenant pour ce faire les étapes suivantes pour chaque filtre de compensation ($6_0$, $6_1$, ..., $6_{M\text{-}1}$) :

l'amenée des échantillons ($\underline{y}(M \cdot v\text{-}p)$) d'un signal d'entrée générés par le convertisseur analogique-numérique au filtre de compensation ($6_0$, $6_1$, ..., $6_{M\text{-}1}$) associé ;
la convolution des échantillons ($\underline{y}(M \cdot v\text{-}p)$) générés par le convertisseur analogique-numérique ($5_0$, $5_1$, ..., $5_{M\text{-}1}$) avec les échantillons de la réponse impulsionnelle ($\underline{h}^T{}_{c,p};h_{c,1}(v)$) du filtre de compensation ($6_0$, $6_1$, ..., $6_{M\text{-}1}$);
**caractérisé**
**en ce que** pour chaque filtre de compensation ($6_0$, $6_1$, ..., $6_{M\text{-}1}$), les étapes suivantes de détermination de la réponse impulsionnelle ($\underline{h}^T{}_{c,p}$; $h_{c,1}(v)$) continue dans le temps sont mises en oeuvre :

l'établissement d'une fonction d'auto-corrélation ($s_{xx}(\tau/T_A)$) continue dans le temps d'un signal d'entrée *(x(t))* destiné à être échantillonné par les différents convertisseurs analogiques-numériques ($5_0$, $5_1$, ..., $5_{M\text{-}1}$) ;
l'établissement des échantillons d'une première fonction de corrélation croisée ($s_{xy_p}(\tau/T_A)$) continue dans le temps par multiplication de la fonction d'auto-corrélation ($s_{xx}(\tau/T_A)$) continue dans le temps à la réponse impulsionnelle ($\underline{h}^T{}_{c,p}$; $h_{c,1}(v)$) continue dans le temps du convertisseur analogique-numérique ($5_0$, $5_1$, ..., $5_{M\text{-}1}$) associé sur un nombre, correspondant à la longueur du filtre, des échantillons ($\underline{y}(M \cdot v\text{-}p)$) générés ;
l'établissement des échantillons d'une deuxième fonction de corrélation croisée ($s_{y_iy_j}(\tau/T_A)$) continue dans le temps par multiplication de la fonction d'auto-corrélation ($s_{xx}(\tau/T_A)$) au produit de la réponse impulsionnelle ($h_p(t/T_A)$) du convertisseur analogique-numérique ($5_0$, $5_1$, ..., $5_{M\text{-}1}$) associé et de la réponse impulsionnelle ($h_p(t/T_A)$) d'un deuxième autre convertisseur analogique-numérique parmi les différents convertisseurs analogiques-numériques ($5_0$, $5_1$, ..., $5_{M\text{-}1}$) sur un nombre, correspondant à la longueur du filtre, des échantillons ($\underline{y}(M \cdot v\text{-}p)$) générés ; et
l'établissement de la réponse impulsionnelle ($\underline{h}^T{}_{c,p}$; $h_{c,1}(v)$) du filtre de compensation ($6_0$, $6_1$, ..., $6_{M\text{-}1}$) sur la base des échantillons établis des première et deuxième fonctions de corrélation croisée ($s_{xy_p}(\tau/T_A)$, $s_{y_iy_j}(\tau/T_A)$), ainsi que la détermination de manière correspondante des coefficients de filtrage du filtre de compensation ($6_0$, $6_1$, ..., $6_{M\text{-}1}$).

2. Procédé de compensation selon la revendication 1,
**caractérisé**
**en ce que** les échantillons ($\underline{y}(M \cdot v\text{-}p)$), générés par tous les convertisseurs analogiques-numériques ($5_0$, $5_1$, ..., $5_{M\text{-}1}$),

du signal d'entrée ($x(t)$) sont amenés au filtre de compensation ($6_0, 6_1, ..., 6_{M-1}$) associé au convertisseur analogique-numérique ($5_0, 5_1, ..., 5_{M-1}$) respectif, dans lequel les échantillons générés par tous les convertisseurs analogiques-numériques ($5_0, 5_1, ..., 5_{M-1}$) sont regroupés de manière à obtenir une suite d'échantillons ($\underline{y}(M \cdot v\text{-}p)$) contenant tous les échantillons.

3. Procédé de compensation selon la revendication 1 ou 2,
   **caractérisé**
   **en ce que**, au cas où le signal d'entrée ($x(t)$) serait inconnu, une fonction sinus cardinal est utilisée comme fonction d'auto-corrélation ($s_{xx}(\tau/T_A)$) au lieu du signal d'entrée ($x(t)$).

4. Procédé de compensation selon la revendication 3,
   **caractérisé**
   **en ce que** la fonction sinus cardinal est limitée en bande à une largeur de bande ($B$) qui correspond à la largeur de bande connue du signal d'entrée ($x(t)$) ou, lorsque la largeur de bande du signal d'entrée ($x(t)$) est inconnue, est réduite par rapport à la fréquence maximale attendue du signal d'entrée ($x(t)$).

5. Procédé de compensation selon l'une quelconque des revendications 1 à 4,
   **caractérisé**
   **en ce que**, au cas où des fonctions de transmission identiques des convertisseurs analogiques-numériques ($5_0, 5_1, ..., 5_{M-1}$) seraient présentes, pour l'établissement des première et deuxième fonctions de corrélation croisée ($s_{xy_p}(\tau/T_A)$, $s_{y_iy_j}(\tau/T_A)$), respectivement la fonction d'auto-corrélation ($s_{xx}(\tau/T_A)$) est utilisée, au cas où seuls des décalages temporels ($\varepsilon_0, \varepsilon_1, ..., \varepsilon_{M-1}$) entre les différents convertisseurs analogiques-numériques ($5_0, 5_1, ..., 5_{M-1}$) seraient différents.

6. Dispositif de compensation de différences de réponse impulsionnelle et de décalage temporel entre plusieurs convertisseurs analogiques-numériques ($5_0, 5_1, ..., 5_{M-1}$) du dispositif montés en parallèle et effectuant chacun un échantillonnage de façon décalée dans le temps les uns par rapport aux autres, présentant chacun une réponse impulsionnelle continue dans le temps établie au moyen d'une mesure de domaine temporel, dans lequel chaque convertisseur analogique-numérique ($5_0, 5_1, ..., 5_{M-1}$) est raccordé à un filtre de compensation ($6_0, 6_1, ..., 6_{M-1}$) associé du dispositif à calculer de manière cyclique présentant une longueur de filtre donnée et une réponse impulsionnelle continue dans le temps à établir,
   **caractérisé en ce que** le dispositif, pour l'établissement des réponses impulsionnelles ($\underline{h}^T_{c,p}$) respectivement associées aux différents filtres de compensation ($6_0, 6_1, ..., 6_{M-1}$), comprend en plus :

   une première unité (1), qui est conçue pour établir une fonction d'auto-corrélation ($s_{xx}(\tau/T_A)$) continue dans le temps d'un signal d'entrée ($x(t)$) destiné à être échantillonné par les différents convertisseurs analogiques-numériques ($5_0, 5_1, ..., 5_{M-1}$),
   une deuxième unité (2), qui est conçue pour établir des échantillons d'une première fonction de corrélation croisée ($s_{xy_p}(\tau/T_A)$) continue dans le temps par multiplication de la fonction d'auto-corrélation ($s_{xx}(\tau/T_A)$) continue dans le temps à la réponse impulsionnelle ($\underline{h}^T_{c,p}$; $h_{c,1}(v)$) continue dans le temps du convertisseur analogique-numérique ($5_0, 5_1, ..., 5_{M-1}$) associé sur un nombre, correspondant à la longueur du filtre, des échantillons ($\underline{y}(M \cdot v\text{-}p)$) générés, et
   une troisième unité (3), qui est conçue pour établir des échantillons d'une deuxième fonction de corrélation croisée ($s_{y_iy_j}(\tau/T_A)$) continue dans le temps par multiplication de la fonction d'auto-corrélation ($s_{xx}(\tau/T_A)$) au produit de la réponse impulsionnelle ($h_p(t/T_A)$) du convertisseur analogique-numérique ($5_0, 5_1, ..., 5_{M-1}$) associé et de la réponse impulsionnelle ($h_p(t/T_A)$) d'un deuxième autre convertisseur analogique-numérique parmi les différents convertisseurs analogiques-numériques ($5_0, 5_1, ..., 5_{M-1}$) sur toute l'étendue d'un nombre, correspondant à la longueur du filtre, des échantillons ($\underline{y}(M \cdot v\text{-}p)$) générés, et le dispositif étant conçu en outre pour établir la réponse impulsionnelle ($\underline{h}^T_{c,p}$; $h_{c,1}(v)$) du filtre de compensation ($6_0, 6_1, ..., 6_{M-1}$) sur la base des échantillons établis des première et deuxième fonctions de corrélation croisée ($s_{xy_p}(\tau/T_A)$, $s_{y_iy_j}(\tau/T_A)$), et dans lequel les coefficients de filtrage du filtre de compensation ($6_0, 6_1, ..., 6_{M-1}$) sont déterminés.

7. Programme informatique comprenant des moyens de code de programme, afin de mettre en oeuvre toutes les étapes selon l'une quelconque des revendications 1 à 5 lorsque le programme est exécuté sur un ordinateur ou un processeur de signal numérique.

8. Produit-programme informatique comprenant des moyens de code de programme mis en mémoire en particulier sur un support lisible par une machine, afin de pouvoir mettre en oeuvre toutes les étapes selon l'une quelconque des revendications 1 à 5, lorsque le programme est exécuté sur un ordinateur ou un processeur de signal numérique.

Fig. 1

Fig. 2

EP 2 453 577 B1

Fig. 3

Fig. 4

Fig. 5

$$t/T_a = Mv-0+\varepsilon_0$$

$h_0(t)$     $\uparrow M$     $h_{c,0}(v)$

$y_0(t/T_a)$

$$t/T_a = Mv-1+\varepsilon_1$$

$x(t)$    $h_1(t)$     $\uparrow M$     $h_{c,1}(v)$

$\hat{x}(Mv-p+\varepsilon_{soll})$

$y_1(t/T_a)$

$$t/T_a = Mv-M+1+\varepsilon_{M-1}$$

$h_{M-1}(t)$     $\uparrow M$     $h_{c,M-1}(v)$

$y_{M-1}(t/T_a)$

$$- \quad e(Mv-p+\varepsilon_{soll})$$

$$t/T_a = Mv-p+\varepsilon_{soll}$$

$x(Mv-p+\varepsilon_{soll})$

## Fig. 6

Start

| |
|---|
| Ermitteln Autokorrelationsfunktion des Eingangssignals |

—S10

| |
|---|
| Ermitteln einer ersten und zweiten Kreuzkorrelationsfunktion aus der Autokorrelationsfunktion und der Impulsantwort eines A/D-Wandlers bzw. der Impulsantworten von zwei A/D-Wandlern |

—S20

| |
|---|
| Ermitteln der Impulsantwort für jedes Kompensationsfilter |

—S30

| |
|---|
| Ermitteln der von Fehlanpassungen kompensierten Abtastwerte der einzelnen A/D-Wandlers durch Falten der vom jeweiligen A/D-Wandler erzeugten Abtastwerte mit der Impulsantwort des zugehörigen Kompensationsfilters und Zusammenfügen der kompensierten Abtastwerte der einzelnen A/D-Wandler zu einem abgetasteten Ausgangssignal |

—S40

Ende

## Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

*   WO 2008156400 A1

**In der Beschreibung aufgeführte Nicht-Patentliteratur**

*   6 Wiener Filters. **SAEED V. VASEGHI.** Advanced Digital signal Processing and Noise Reduction. John Wiley & Sons Ltd, 01. Januar 2000, 178-204